# EUROPEAN PATENT SPECIFICATION

(11) **EP 1 835 512 B1**
(45) Date of publication and mention of the grant of the patent: **12.05.2010**
(21) Application number: 05790645.5
(22) Date of filing: 07.10.2005
(51) Int. Cl.: H01B 1/22, H01B 1/00, H05K 1/09, C09D 11/00

(54) **CONDUCTIVE INK**
LEITFÄHIGE TINTE
ENCRE CONDUCTRICE

(30) Priority: 08.10.2004 JP 2004296987; 19.10.2004 JP 2004303863
(43) Date of publication of application: 19.09.2007
(73) Proprietor: MITSUI MINING & SMELTING CO., LTD., Tokyo 141-8584 (JP)
(72) Inventor: KAMIKORIYAMA, Yoichi c/o MITSUI MINING & SMELTING, Haraichi,Ageo-shi, Saitama 3620021 (JP); OGATA, Sumikazu c/o MITSUI MINING & SMELTING CO.,, Ageo-shi, Saitama 3620021 (JP); ANAI, Kei c/o MITSUI MINING & SMELTING CO., LTD., Ageo-shi, Saitama 3620021 (JP); SAWAMOTO, Hiroki c/o MITSUI MINING & SMELTING CO.,, Ageo-shi, Saitama 3620021 (JP)
(74) Representative: Bohmann, Armin K.
(86) International application number: PCT/JP2005/018631
(87) International publication number: WO 2006/041030

(56) References cited:
- EP-A- 1 422 268
- WO-A-2004/005413
- JP-A- 2001 113 727
- JP-A- 2002 109 957
- JP-A- 2002 109 957
- JP-A- 2002 356 602
- JP-A- 2004 168 940
- JP-A- 2004 256 757
- JP-A- 2004 277 507

## Description

### Technical Field

The present invention relates to a method for forming a circuit by using a conductive metal ink, more particularly to a metal ink that makes it possible to form high density metal wiring and electrodes at low temperature on ceramic substrates, glass substrates, plastic substrates such as typically a polyimide substrate, and so on, and to a method for manufacturing the metal ink. The present invention also relates to a conductive ink that makes it possible to form a circuit by printing a circuit shape etc. by ink jet printing system etc. and hardening the circuit patterns etc.

### Background Art

Conventionally, as a method for forming circuit patterns on various kinds of substrates, there are methods using photolithography, etching, and screen printing as disclosed in Patent Documents 1 and 2. Among such conventional methods, there have been widely used a method for forming circuit patterns by etching a copper foil of a copper-clad laminate; and a method for directly forming wiring or electrode patterns on a surface of a substrate by screen printing a conductive paste which is a paste produced by mixing a metal powder with a solvent and a resin. The method for directly forming circuits on a surface of a substrate by using a metal powder processed to be a paste (hereafter just referred to as "a conductive paste") oranink (hereafter j ust referred to as "a conductive ink") and with methods such as screen printing which have been used in other fields has been widely used because of less process steps and production cost can be remarkably reduced when compared to the etching method for forming circuits by etching a copper foil of a copper-clad laminate.

And in recent years, conductive circuit patterns in thin displays such as personal digital assistants or TV sets are going to higher density year by year. Thus targets examined are not only a wiring width of 40 µm or less, but also forming circuit patterns on flexible resin substrates by low-temperature baking. In forming circuit patterns by screen printing traditionally used, a line width of around 100 µm shows no open circuits and excellent wiring shapes. But it is substantially difficult to form finer wiring, in particular a line width of 40 µm or less. As a method for forming circuit patterns on various kinds of substrates by low-temperature baking, a silver ink that contains silver nano-particles has been examined as shown in Patent Document 3.

On the other hand, as for liquid pastes (hereafter just referred to as "conductive metal inks") obtained by mixing a metal powder with a large amount of organic solvents and resins, various kinds of conductive metal inks are proposed as materials for forming ultra fine circuit patterns by a coating method with a dispenser or ink jet printing methods as shown in Patent Document 4. However, it becomes eventually difficult to form circuits having low resistance with the conductive metal inks because adhesion strengths of the conductive metal inks to various substrates depend on kinds of organic resins, and gas generation by decomposition of organic resin components in a baking process in reduction atmosphere with hydrogen or nitrogen which is popular to use for forming wiring and electrodes having low resistance cause fine cracks, and thereby bulk densities of wiring and electrodes become low.

As composition of a conductive ink, Patent Document 5 discloses an aqueous nickel slurry containing water, a nickel fine powder in which an insoluble inorganic oxide is coated on the surface of each particles of the powder, polyacrylic acid, an ester or a salt thereof and organic functional group substituted ammonium hydroxide; and a conductive paste containing the aqueous nickel slurry and a binder. In the aqueous nickel slurry, the nickel fine powder is dispersed at high concentration with stability without re-agglomeration. The aqueous nickel slurry causes no problem when a metal powder is sintered by high-temperature baking such as typically fabricating an internal electrode of a multilayer ceramic capacitor. However, in the recent application of forming circuits on various kinds of substrates at low temperature, the slurry causes a problem that the circuits cannot be formed because adhesion strength of the slurry to various substrates is substantially zero.

Furthermore, in forming ultra fine circuit patterns by using ink jet printing methods, it is substantially difficult to form circuits by industrial continuous printing because of lack of suitable surface tension for printing of the ink, causing the ink to clog a nozzle in forming circuits by continuous printing and a phenomenon that the ink does not hit a target printing position also. Moreover, the ink does not contain a binder that causes the adhesion strength to substrates, and thus even if the ink can be printed on substrates by making some arrangements in printing procedures, the adhesion strength to the substrates is substantially zero. Therefore, it is substantially difficult to form circuits except for the purpose of sintering a metal powder by high-temperature baking such as typically fabricating an internal electrode of a multilayer ceramic capacitor.

Patent Document 1: Japanese Patent Laid-Open No. H09-246688
Patent Document 2: Japanese Patent Laid-Open No. H08-18190
Patent Document 3: Japanese Patent Laid-Open No. 2002-334618
Patent Document 4: Japanese Patent Laid-Open No. 2002-324966
Patent Document 5: Japanese Patent Laid-Open No. 2002-317201

As understood from what is mentioned above, in order to form the above-mentioned fine circuits at low temperature, the coating method with a dispenser and the printing method with ink jet device using conductive metal inks are examined. However, there is a problem of their low adhesion strengths or no adhesion to various kinds of substrates. As a result, such inks cannot be used by the ink jet printing method.

Conventional conductive metal inks adopt organic resin components as a binder to improve their adhesion to substrates. Therefore, when circuits are printed on ceramic, glass, and plastic substrates such as a polyimide substrate, and subj ected to reduction firing at low temperature of 300t or less, the resin components contained decompose to generate gas due to heating or reducing gas. As a result, high adhesion strength to various kinds of substrates can not be obtained.

As shown described above, a conductive metal ink having excellent adhesion to substrates and making it possible to form fine wiring and electrodes has been demanded. Furthermore, it is preferable that the conductive ink can also be used for continuous printing in printing ultra fine wiring or electrodes on substrates with an ink jet device and a dispenser device to form circuits. And it is more preferable that the ink can further improve the adhesion between the printed electrodes etc. and the substrates.

### Disclosure of the Invention

The inventors of the present invention have thoroughly studied. As a result, the inventors have found that a conductive ink comprising a solvent, a metal powder, and an adhesion improver can achieve the above-mentioned objects, and thus the present invention has been accomplished.

As for a basic composition of a conductive ink according to the present invention, the conductive ink comprises a solvent, a metal powder and an adhesion improver. The ink is also characterized in that the adhesion improver is one or mixture selected from the group consisting of a silane coupling agent, a titanium coupling agent, a zirconium coupling agent, and an aluminum coupling agent.

And, the conductive ink becomes suitable for ink jet printers by adjusting the solvent with a surface tension adjustor to have a surface tension in the range of 15 mN/m to 50 mN/m.

The surface tension adjustor is preferably one or mixture selected from the group consisting of alcohols and glycols, each having a boiling point of from 100 to 300°C at ambient pressure.

Furthermore, in the conductive ink according to the present invention, the solvent is preferably one or mixture selected from the group consisting of water, alcohols and saturated hydrocarbons each having a boiling point of 300°C or less at ambient pressure.

In the conductive ink according to the present invention, the metal powder is selected from a nickel powder, a silver powder, a gold powder, a platinum powder, a copper powder, and a palladium powder; and a primary particle size of the metal powder of 500 nm or less is preferred.

And in view of using the conductive ink according to the present invention for ink jet printers, agglomerate particles contained in the metal powder may preferably have the maximum particle size of 0.8 µm or less.

In the conductive ink according to the present invention, the metal powder is preferably an inorganic oxide coated nickel powder in which an insoluble inorganic oxide is coated to surfaces of particles of the powder.

In the conductive ink according to the present invention, the insoluble inorganic oxide of the inorganic oxide coated nickel powder contains at least one element selected from the group consisting of silicon dioxide, aluminum oxide, zirconium oxide, and titanium oxide.

In the conductive ink according to the present invention, one or mixture selected from groups of (a) polyacrylic acids, esters or salts thereof; (b) organic functional group substituted ammonium hydroxides; and (c) hydroxyl functional group containing amine compounds is preferably added as a dispersing agent.

And in view of using the conductive ink according to the present invention for ink jet printers, a viscosity of the ink is preferably 60 cP or less at 25°C.

The conductive ink according to the present invention is a conductive metal ink having excellent adhesion to various kinds of substrates such as a glass substrate, and making it possible to form fine wiring or electrodes. The conductive ink also has excellent adhesion to circuits etc. formed by other elements. Therefore, the conductive ink can be used for forming protective electrodes or protective films on glass substrates, the surfaces of ITO transparent electrodes and the surfaces of circuits formed with a silver paste for use of TFT panel, and so on. Furthermore, the conductive ink according to the present invention is suitable for forming accurate and fine wiring or electrodes by adopting the coating method with a dispenser or the ink jet printing system.

### Best Mode for Carrying Out the Invention

The conductive ink according to the present invention comprises a solvent, a metal powder, and an adhesion improver. And the present invention is characterized in that the adhesion improver is one or mixture selected from the group consisting of a silane coupling agent, a titanium coupling agent, a zirconium coupling agent, and an aluminum coupling agent.

The adhesion improver described above is selected from the group consisting of a silane coupling agent, a titanium coupling agent, a zirconium coupling agent, and an aluminum coupling agent. In this case, not only one component but also mixture of two or more selected from the group can be used. In this way, containing plural components makes it possible to control the adhesion property meet with characteristics of a substrate on which circuits etc. are formed suitably.

As the silane coupling agent mentioned above, any of the following is preferably used: vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminotriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl) tetrasulfide, 3-isocyanatopropyltriethoxysilane, tetramethoxysilane, tetraethoxysilane, methyltrimethoxysilane, methyltriethoxysilane, dimethyltriethoxysilane, phenyltriethoxysilane, hexamethyldisilazane, hexyltrimethoxysilane and decyltrimethoxysilane. Among these, in view of achieving stability of the adhesion property to substrates, methyltrimethoxysilane, methyltriethoxysilane, dimethyltriethoxysilane, or the like which shows the stable performance is preferably used.

As the titanium coupling agent mentioned above, any of the following is preferably used: tetra isopropyl titanate, tetra normal butyl titanate, butyl titanate dimmer, tetra (2- ethylhexyl) titanate, tetra methyl titanate, titanium acetyl acetonate, titanium tetra acetyl acetonate, titanium ethyl acetoacetate, titanium octane diolate, titanium lactate, titanium triethanolaminate, and polyhydroxytitaniumstyrene stearate. Among these, in view of achieving stability of the adhesion property to substrates, tetra isopropyl titanate, tetra normal butyl titanate, titanium lactate, and so on which exhibit the stable performance are preferably used.

As the zirconium coupling agent mentioned above, any of the following is preferably used: zirconium normal propylate, zirconium normal butylate, zirconium tetra acetyl acetonate, zirconium mono acetyl acetonate, zirconium bis acetyl acetonate, zirconium mono ethyl acetoacetate, zirconium acetyl acetonate bis ethyl acetoacetate, zirconium acetate, and zirconium mono stearate. Among these, in view of achieving stability of the adhesion property to substrates, zirconium normal propylate, zirconium normal butylate, zirconium tetra acetyl acetonate, zirconium mono acetyl acetonate, zirconium bis acetyl acetonate, zirconium mono ethyl acetoacetate, zirconium acetyl acetonate bis ethyl acetoacetate, zirconium acetate, and so on which exhibit the stable performance are preferably used.

As the aluminum coupling agent mentioned above, any of the following is preferably used: aluminum isopropylate, mono sec-butoxy aluminum diisopropylate, aluminum sec-butylate, aluminum ethylate, ethyl acetoacetate aluminum diisopropylate, aluminum tris(ethyl acetoacetate), alkyl acetoacetate aluminum diisopropylate, aluminum monoacetyl acetonate bis(ethyl acetoacetate), aluminum tris(acetyl acetonate), aluminum monoisopropoxy monooleoxy ethylacetoacetate, cyclic aluminum oxide isopropylate, cyclic aluminum oxide octylate, and cyclic aluminum oxide stearate. Among these, in view of achieving stability of the adhesion property to substrates, ethyl acetoacetate aluminum diisopropylate, aluminum tris (ethyl acetoacetate), alkyl acetoacetate aluminum diisopropylate, aluminum mono acetyl acetonate bis (ethyl acetoacetate), aluminum tris (acetyl acetonate), and so on which exhibit the stable performance are preferably used.

Then explanation on the solvent will be given. As the solvent according to the present invention, water, organic solvents, etc. can be widely used. The solvent is not particularly restricted as long as the solvent at least which has compatibility with the adhesion improver, and the solvent can be adjusted to have a given paste viscosity, etc. Therefore, the solvent is, if to be restricted, one or mixture selected from the group consisting of water, alcohols and saturated hydrocarbons which has a boiling point of 300°C or less at ambient pressure.

The reason for the restriction "having a boiling point of 300°C or less at ambient pressure" is that use of solvents having a boiling point in the temperature range greater than 300°C makes it impossible to form dense electrodes and exhibit high adhesion strength to various kinds of substrates also eventually because such solvents gasify at high temperature as in the case of gasifying of conductive inks using organic resin components as a binder resin in a procedure of reduction firing due to decomposition of the binder resin.

In the case of using water as the solvent, the water has purity as with ion exchanged water, distilled water, etc., and does not include water having a purity of city water etc.

In the case of using alcohols as the solvent, one or mixture selected from the following alcohols is preferably used: 1-propanol, 1-butanol, 1-pentanol, 1-hexanol, cyclohexanol, 1-heptanol, 1-octanol, 1-nonanol, 1-decanol, glycidol, benzyl alcohol, methylcyclohexanol, 2-methyl-1-butanol, 3-methyl-2-butanol, 4-methyl-2-pentanol, isopropyl alcohol, 2-ethylbutanol, 2-ethylhexanol, 2-octanol, terpineol, dihydroterpineol, 2-methoxyethanol, 2-ethoxyethanol, 2-n-butoxyethanol, 2-phenoxyethanol, carbitol, ethylcarbitol, n-butylcarbitol and diacetone alcohol. Among these, preferred alcohols have a boiling point of 80°C or higher at ambient pressure and have a tendency not to vaporize at room temperature at ambient pressure. And the following alcohols are more preferably used: 1-butanol, 1-octanol, terpineol, dihydroterpineol, 2-methoxyethanol, 2-ethoxyethanol, 2-n-butoxyethanol, and diacetone alcohol.

In the case of using saturated hydrocarbons as the solvent, one or mixture selected from the following saturated hydrocarbons is preferably used: heptane, octane, nonane, decane, undecane, dodecane, tridecane, tetradecane, pentadecane, and hexadecane. Among these, decane, undecane, dodecane, tridecane, and tetradecane are more preferably used. This is because these have a boiling point of 300°C or less at ambient pressure, have low vapor pressure and are hard to vaporize at room temperature, and thus can be handled easily.

The conductive ink described so far can obtain the surface tension most suitable for the ink jet printing system by using a surface tension adjustor. That is, adjusting the conductive ink according to the present invention to have a surface tension in the range of 15 mN/m to 50 mN/m makes it easy to form circuits etc. by the ink jet method or the dispenser method. Accordingly, as for an addition amount of the surface tension adjustor which will be described later, various kinds of agents etc. are added so that the conductive ink has a surface tension generally from 15 mN/m to 50 mN/m, preferably from 20 mN/m to 40 mN/m. When the surface tension of the conductive ink is out of the range, ink jet nozzles may not jet the conductive ink, or even if the nozzles can jet the conductive ink, such phenomena that deviation from a target printing position may occur or continuous printing cannot be performed. Therefore, in the present invention, the conductive ink is adjusted to have a surface tension in the range suitable for using the ink jet method, whereby fine circuit wiring etc. can be formed with an ink jet device.

When considering on the surface tension of such a conductive ink, combination of the solvent and the surface tension adjustor should be discussed. Then at first, description of solvents in the case with consideration of adjusting the surface tension will be given. When adjusting the surface tension is considered, the solvent may be an organic solvent alone or may further contain water. In the case of using water as the solvent, the water to be used has a purity level as with ion exchanged water, distilled water, etc., and does not include water having a purity of city water etc.

Then in the case of using a mixture of water, an organic solvent, etc. as the solvent, the solvent is not particularly restricted as long as the solvent at least which has compatibility with the water, the dispersing agent, and the adhesion improver, and can be adjusted to have a given ink viscosity, etc. In this case, about 3 to 5000 parts by weight of an organic solvent, etc. are mixed with 100 parts by weight of water for fine adjustment on the viscosity of a conductive ink, the dispersibility of a metal powder, etc. In particular, it is required to select and use the organic solvent, etc. in consideration of combination with a metal powder type to be used. Therefore, the organic solvent, etc. is, if restricted, to one or mixture selected from the group consisting of water, alcohols and glycols each having a boiling point of from 100 to 300°C at ambient pressure.

The reason for the restriction "having a boiling point of from 100 to 300°C at ambient pressure" is that use of solvents having a boiling point in the temperature range greater than 300°C makes it impossible to form dense electrodes and also exhibit high adhesion strength to various kinds of substrates eventually because such solvents gasify at high temperature as with gasifying of conductive inks using organic resin components as a binder resin in a procedure of reduction firing due to decomposition of the binder resin. And the reason for the restriction of 100°C or higher is that this temperature is the boiling point of water or higher, and thus this restriction makes it possible to select a heating temperature range that ensures removal of water which is inevitably contained in the solvents.

In the case of using alcohols as the solvent, one or mixture selected from the following alcohols is preferably used: 1-butanol, 1-pentanol, glycidol, benzyl alcohol, 3-methyl-2-butanol, 4-methyl-2-pentanol, 2-methoxyethanol, 2-ethoxyethanol, 2-n-butoxyethanol, 2-phenoxyethanol, carbitol, ethyl carbitol, n-butyl carbitol, and diacetone alcohol. Among these, preferred alcohols have a boiling point of 100°C or higher at ambient pressure and are hard to vaporize at room temperature at ambient pressure. And the following alcohols are more preferably used: 1-butanol, 1-pentanol, 2-methoxyethanol, 2-ethoxyethanol, 2-n-butoxyethanol, 2-phenoxyethanol, and diacetone alcohol.

In the case of using glycols as the solvent, one or mixture selected from the following glycols is preferably used: ethylene glycol, diethylene glycol, triethylene glycol, tetraethylene glycol, propylene glycol, trimethylene glycol, dipropylene glycol, tripropylene glycol, 1,2-butylene glycol, 1,3-butylene glycol, 1,4-butylene glycol, pentamethylene glycol, and hexylene glycol. Among these, preferred glycols have a viscosity of 100 cP or less, and the following glycols are preferably used: ethylene glycol, diethylene glycol, propylene glycol, 1, 4-butylene glycol, and triethylene glycol. This is because excessively high viscosity makes it difficult to adjust the viscosity to be suitable for the dispenser method or the ink jet method.

Then as for the surface tension adjustor, an additive having a surface tension of 40 mN/m or less is used. Use of a surface tension adjustor having such a surface tension enables the easiest adjustment of surface tension of an ink suitable for an ink jet device, and easy adjustment of viscosity to suit with the design of an ink jet device. And thus fine wiring circuits can be formed. As the surface tension adjustor mentioned above, one or mixture selected from the group consisting of alcohols and glycols that can also be used as solvents, have a surface tension of 40 mN/m or less, and have a viscosity of 100 cP or less at 25°C is preferably used.

Among the adjustors of surface tension, examples of alcohols etc. having a surface tension of 40 mN/m or less, and having a viscosity of 100c Por less at 25°C may include: 1-butanol, 1-pentanol, 4-methyl-2-pentanol, 2-ethoxyethanol, 2-n-butoxyethanol, n-butyl carbitol and so on. In the present invention, 2-n-butoxyethanol or 1-butanol is preferably used among the above adjustors of surface tension in view of maintaining reliability as a conductive ink for a long time.

In the conductive ink according to the present invention, an amount of the surface tension adjustor to be blended may be selected to properly adjust the surface tension of the conductive ink, and not particularly restricted. However, the amount is generally from 1wt% to 50 wt%, preferably from 3wt% to 30 wt% in the conductive ink. When the amount of the surface tension adjustor is less than 1 wt%, the surface tension cannot be adjusted. On the other hand, when the surface tension adjustor is added with an amount of 50 wt% or more, dispersion state of metal powder of minute particles contained in the conductive ink changes considerably before and after the addition of the surface tension adjustor. As a result, the metal powder of minute particles starts to agglomerate, and uniform dispersion of the metal powder of minute particles, which is the most important for conductive inks, is inhibited. Thus such an ink cannot be used as a conductive ink.

As for the metal powder described above, powder properties thereof such as particle size or dispersibility are not particularly limited. And the metal powder is intended to include all kinds of particles like spherical particles, flaky powder, or particles each having a coated layer on the surface. However, the main target of the conductive ink according to the present invention is forming circuits of electronic materials. Therefore, the metal powder is expected to be what is selected from a nickel powder, a silver powder, a gold powder, a platinum powder, a copper powder, and a palladium powder, which are used considerably for electronic materials, and has a primary particle size of 500 nm or less.

Furthermore, in consideration of using the metal powder with the ink jet printing system, it is natural that the metal powder preferably has an average primary particle size of 500 nm or less. When the average primary particle size exceeds 500 nm, a conductive ink is extremely likely to clog an ink jet nozzle, and thus it becomes difficult to conduct continuous printing. Even if printing can be conducted, a film thickness of wiring or an electrode to be formed becomes too thick, therefore fine wiring as a target is not obtained.

More specifically, depending on the fine level of a circuit tobe formed, a metal powder of minute particles having an appropriate primary particle size may be properly selected and used. However, in view of the concept of a metal powder of minute particles, a powder having a primary particle size generally in the range of from 3 to 500 nm, preferably from 5 to 200 nm, and more preferably from 10 to 150 nm is preferably selected and used. As for the case of a metal powder of minute particles having an average primary particle size of less than 3 nm, a manufacturing method thereof is not established yet at present, and thus verification by experiments cannot be conducted. On the other hand, when the average primary particle size exceeds 500 nm, it is difficult to form wiring or electrodes having a width of 40 µm or less as a target, and a film thickness of formed wiring or electrodes become too thick and thus improper. There is such a tendency that finer average primary particle size of a metal powder of minute particles lessen causing of the powder clogging of ink jet nozzles and it is more suitable for forming fine circuits. In the present invention, the average primary particle size means a particle size obtained by averaging sum of diameters of at least 200 particles ina fieldof view of observation with a scanning electron microscope.

Small average primary particle size of a metal powder of minute particles is a reason for being fine particles. However, even fine particles also come to tend to cause clogging of ink jet nozzles when agglomeration among particles in a conductive ink proceeds to increase a particle size as a secondary structure. Therefore, it is necessary to make an agglomerate particle as a secondary structure of a metal powder of minute particles in a conductive ink to have a size that does not cause clogging of ink jet nozzles or smaller. It is established in experiments that agglomerate particles having the maximum particle size of 0. 8 µm or less almost certainly prevent clogging of ink jet nozzles. To check the agglomerate particles, a laser particle size distribution measuring device is used.

Furthermore, in consideration of shelf life, sintering properties, etc. of a conductive ink, those having properties required for a conductive ink, such as a metal powder whose surface is treated with oleic acid, stearic acid, etc. , or an oxide-coated powder in which specific oxide is coated to the surface of particles thereof may be used selectively. In particular, in consideration of using a nickel powder for the conductive ink according to the present invention, an inorganic oxide coated nickel powder in which an insoluble inorganic oxide is coated to the surface of particles thereof is preferably used.

And as for the insoluble inorganic oxide coated to the surface of particles of an inorganic oxide coated nickel powder, silicon dioxide, aluminum oxide, zirconium oxide, titanium oxide, barium titanate, calcium zirconate, etc. are acceptable. Among these, an oxide containing one or more elements selected from the group consisting of silicon dioxide, aluminum oxide, zirconium oxide, and titanium oxide is preferably used. Furthermore, among these, silicon dioxide is preferably used because silicon dioxide is coated with stability particularly to the surface of particles of a nickel powder.

For forming an insoluble inorganic oxide layer on the surface of particles of a nickel powder, various methods can be adopted. For example, such a method may be adopted that a nickel powder, a powdery insoluble inorganic oxide, and media (like zirconium beads) are placed in a mixing agitator and agitated to adhere the insoluble inorganic oxide to the surface of particles of the nickel powder.

Another method can be adopted for adhering an insoluble inorganic oxide to the surface of particles of a nickel powder; a nickel powder and an insoluble inorganic oxide are dispersed in water, and then the water is removed by drying to adhere the insoluble inorganic oxide to the surface of particles of the nickel powder. In this case, an insoluble inorganic oxide having an average primary particle size that is 0.2 times or less, preferably 0.15 times or less, than the average primary particle size of particles that constitute the nickel powder is preferably used. This is because in adhering an insoluble inorganic oxide powder to the surface of particles of a nickel powder, use of an insoluble inorganic oxide powder having a finer particle size tends to result in more uniform adhering.

In the case of using an oxide-coated nickel powder in the present invention, an amount of the insoluble inorganic oxide coated to the surface of nickel fine particles is generally from 0.05 to 10 wt%, preferably from 0.1 to 5 wt%, more preferably from 0.5 to 2 wt% when the weight of nickel is 100 wt%. When the amount of the insoluble inorganic oxide is less than 0.05 wt%, increase of the life of a conductive ink, which is intended as a result of providing an oxide-coated layer, is not achieved. On the other hand, when the amount of the insoluble inorganic oxide exceeds 10 wt%, the oxide-coated layer becomes thick and an uneven coated layer is formed on the surface of the particles. Thus smoothness of the surface of the particles is lost, whereby the ink causes unintended increase of viscosity. The range shown as more preferable is used for achieving more certainly the meaning of the upper limit and the lower limit described above in industrial production process.

As described above, use of an oxide-coated nickel powder enables increase of the life of a conductive ink because re-agglomeration of the nickel powder is effectively prevented even when the conductive ink contains the nickel powder in a high concentration.

Furthermore, to a conductive ink according to the present invention, in particular a nickel ink, is preferably added a dispersing agent if required. As the dispersing agent, one or mixture selected from the groups of (a) polyacrylic acids, esters or salts thereof; (b) organic functional group substituted ammonium hydroxides; and (c) hydroxyl functional group containing amine compounds is preferably added.

Examples of (a) polyacrylic acids, esters or salts thereof used in the present invention are polyacrylic acid, poly (methyl acrylate), sodium polyacrylate, ammonium polyacrylate, and so on. Among these, ammonium polyacrylate is preferably used because ammonium polyacrylate easily coordinate with the surface of metal particles, and coordinated ammonium polyacrylate also reduces agglomeration of the metal particles in a solvent by electrical repulsion and the steric inhibition effect. As for (a), one or mixture selected from what is mentioned above can be used in the present invention.

Examples of (b) organic functional group substituted ammonium hydroxides used in the present invention are alkyl functional group substituted ammonium hydroxides such as tetramethylammonium hydroxide, tetraethylammonium hydroxide or tetrabutylammonium hydroxide; and alkyl functional group substituted and aryl functional group substituted ammonium hydroxides such as trimethylphenylammonium hydroxide or benzyltrimethylammonium hydroxide. Among these, the alkyl functional group substituted ammonium hydroxides are preferably used because alkyl functional group substituted ammonium hydroxides easily coordinate with metal particles and have high electrical repulsion. As for (b), one or mixture selected from what is mentioned above can be used in the present invention.

Examples of (c) hydroxyl functional group containing amine compounds used in the present invention are alkanolamines. Among these, dialkanolamines such as dimethanolamine, diethanolamine or dipropanolamine are preferably used because dialkanolamines have high wettability with metal particles. And diethanolamine is more preferable because diethanolamine most effectively reduces agglomeration of metal particles after aging. As for (c), one or mixture selected from what is mentioned above can be used in the present invention.

In the present invention, the dispersing agent mentioned above is added to a conductive nickel ink, whereby reagglomeration of particles of a nickel powder in the ink is prevented. The dispersing agent used in the present invention is at least one in the (a) to (c). Among (a) to (c), use of (a) and (c) together is preferable because the nickel powder can be dispersed with more stability.

When the conductive ink according to the present invention contains "polyacrylic acids, esters or salts thereof", an amount of "polyacrylic acids, esters or salts thereof" per 100 parts by weight of a metal powder is generally from 0.05 to 5 parts by weight, preferably from 0.1 to 2 parts by weight because adhesion of the ink to a substrate is not inhibited and the ink may have the longest shelf life.

When the conductive ink according to the present invention contains "organic functional group substituted ammonium hydroxides" , an amount of "organic functional group substituted ammonium hydroxides" per 100 parts by weight of a metal powder is generally from 0.01 to 5 parts by weight, preferably from 0.05 to 1 parts by weight because adhesion of the ink to a substrate is not inhibited and the ink may have the longest shelf life.

When the conductive ink according to the present invention contains "hydroxyl functional group containing amine compounds", an amount of "hydroxyl functional group containing amine compounds" per 100 parts by weight of nickel is generally from 0.5 to 20 parts by weight, preferably from 5 to 15 parts by weight because adhesion of the ink to a substrate is not inhibited and the ink may have the longest shelf life.

When a dispersing agent is used in the conductive ink according to the present invention in combination, and the ink contains "polyacrylic acids, esters or salts thereof" and "organic functional group substituted ammonium hydroxides", an amount of "organic functional group substituted ammonium hydroxides" per 100 parts by weight of "polyacrylic acids, esters or salts thereof" is generally from 1 to 30 parts by weight, preferably from 5 to 20 parts by weight because adhesion of the ink to a substrate is not inhibited and the ink may have the longest shelf life.

Explanations on a viscosity of a conductive ink will be given. In the present invention, in order to form circuits etc. by the dispenser method or the ink jet method easier, the conductive ink has a viscosity of 60 cP or less at 25°C. Adjusting the viscosity in the present invention is achieved by optimally blending the solvent, the dispersing agent, and the oxide-coated metal powder mentioned above. The reason why the lower limit of the viscosity is not described is because conductive inks each containing a different metal are used for forming circuits in different places and for different objects, and wiring, electrode size and shape to be desired are different. When the viscosity exceeds 60 cP at 25°C, in an attempt to form fine wiring or electrodes by using the ink jet method or the dispenser method, it becomes difficult for a nozzle to stably jet droplets of a conductive ink because the viscosity of the conductive ink is too high in comparison with energy applied to the nozzle to jet the conductive ink. It is experimentally demonstrated that fine wiring or electrodes can be formed by using the ink jet method or the dispenser method when the viscosity is 60 cP or less at 25°C.

Examples are shown hereinafter, however, the present invention is not interpreted as being limited to these examples. First, Examples 1 to 4 shows examples on a formed conductive film mainly evaluating adhesion between a substrate.

### Example 1

### (Nickel Powder)

In this Example, an oxide-coated nickel powder was used as the nickel powder. The method for manufacturing the oxide-coated nickel powder is described as follows.

10 L of pure water was added to a 20-L-volume container. And 4000 g of a nickel powder (NN-100 manufactured by MITSUI MINING & SMELTING CO., LTD., an average diameter of primary particles: 100 nm) was added slowly to the container with stirring at 200 rpm, and the stirring was kept for 20 minutes. Then 200 g of 20 wt% colloidal silica (SNOWTEX 0 manufactured by Nissan Chemical Industries, Ltd., an average diameter of primary particles: 20 nm) was added to this mixture, and further the stirring was kept for 20 minutes to obtain a dispersion fluid.

Then in order to obtain the state that the colloidal silica was mixed uniformly with the nickel powder in the dispersion fluid, mixing treatments were conducted continuously by using T. K. FILMICS (manufactured by Tokushu Kika Kogyo), which is a high-speed emulsifying disperser, to obtain a slurry having the state that the colloidal silica was mixed uniformly with the nickel. Subsequently, this slurry was subjected to a drying treatment with a vacuum dryer for 24 hours under the conditions with a vacuum degree of 50 Torr or less, and the temperature in the dryer of 120°C to obtain a dry powder in which the silica was coated to the surface of particles of the nickel powder. After that, this dry powder was crushed with a Henschel mixer (manufactured by MITSUI MINING COMPANY, LIMITED), and then classified with a 20 µm sieve to remove coarse particles. Then in order to improve adhesion of the silica which was on the surface of powdery nickel particles passed through the 20 µm sieve to the surface of the nickel particles, additional heat treatment was conducted with a vacuum dryer for 24 hours under the conditions, a vacuum degree of 10 Torr or less and the temperature in the dryer of 150°C to obtain a silica-coated nickel powder (hereafter referred to as "nickel powder A"). The nickel powder A was a powder in which silica was coated to the surface of nickel fine particles.

### (Dispersing Agent)

380 g of diethanolamine (manufactured by Wako Pure Chemical Industries, Ltd.), 45.6 g of 44% solution of ammonium polyacrylate (manufactured by Wako Pure Chemical Industries, Ltd.), and 13.4 g of 15% solution of tetramethyl ammonium (manufactured by Wako Pure Chemical Industries, Ltd.) was added to a 1-L-volume beaker, and stirred with a magnetic stirrer to prepare a dispersing agent (hereafter referred to as "dispersing agent A").

### (Preparation of Conductive Ink)

0.7 L of pure water as a solvent was added to a 1-L-volume container. And 300 g of the nickel powder A of Example 1 was slowly added to the container with stirring at 200 rpm, and further 40.3 g of the dispersing agent A was added thereto. Then the stirring was kept for 20 minutes to obtain a slurry.

After that, the slurry was subjected to dispersing treatments continuously by using T.K. FILMICS (manufactured by Tokushu Kika Kogyo), which is a high-speed emulsifying disperser, and then 0.96 L of pure water was added thereto to obtain a slurry with a nickel content of 15 wt%.

Next, 1 µm or larger particles contained in the slurry were removed by filtering the slurry with a cartridge type filter (MCP-JX-E10S manufactured by Advantec Toyo Kaisha, Ltd., an average pore size: 1 µm or less) . Furthermore, in order to remove 0.8 µm or larger particles, the slurry was filtered with Mixed Cellulose Ester Membrane Filter A065A293C (manufactured by Advantec Toyo Co., Ltd., an average pore size: 0.65 µm) to obtain a filtrate (nickel slurry A).

### (Preparation of Conductive Ink)

65.8 g of titanium lactate (TC-315 manufactured by Matsumoto Pure Chemical Industries, Ltd.) was added to the nickel slurry A as an adhesion improver, and stirred at 200 rpm for 30 minutes to obtain a conductive ink (conductive ink A of Example 1).

### (Formation of Electrode and Evaluation thereof)

The conductive ink A of Example 1 was coated to a 4 cm square alkalifree glass substrate OA-10 (manufactured by Nippon Electric Glass Co., Ltd.) with a spin coater at a rate of 2000 rpm to form a film. After that, the film-coated glass substrate was subjected to reduction firing in a hydrogen - helium mixed atmosphere containing hydrogen of 2 volume percent, at 300t for 2 hours to form a nickel electrode film on the glass substrate. Observation with SEM showed that the electrode had a thickness of about 1 µm. A resistivity of the nickel electrode film was measured with a 4-pin probe Resistivity Meter Loresta-GP (manufactured by Mitsubishi Chemical Corporation). And adhesion of the nickel electrode film to the glass substrate was examined by the crosscut method according to JIS K paragraph 5-6. The resistivity was 3.8 × 10⁻³ Ω·cm. The adhesion was evaluated to be class 0, which means that excellent adhesion was obtained. Furthermore, the nickel electrode film was subjected to ultrasonic rinsing in water for 10 minutes, followed by ultrasonic rinsing in acetone for 10 minutes. Thus obtained nickel electrode film was examined with a microscope and no delamination of the film was observed.

### (Formation of Fine Electrode and Evaluation thereof)

A nozzle that was processed to have a bore diameter of 25 µm at the tip of the nozzle was attached to a coating dispenser (manufactured by Musashi Engineering, Inc.) to allow the dispenser to apply a conductive ink continuously. By using this dispenser, the conductive ink A of Example 1 was applied to a 4 cm square alkalifree glass substrate OA-10 (manufactured by Nippon Electric Glass Co., Ltd.) to form a nickel electrode film. After that, the glass substrate was subjected to reduction firing in a hydrogen - helium mixed atmosphere containing 2 volume percentage of hydrogen, at 300°C for 2 hours to form a nickel electrode film on the glass substrate. Measurement with a microscope showed that the electrode had a width of about 40 µm. The obtained nickel electrode film was subjected toultrasonic rinsing inwater for 10 minutes, followed by ultrasonic rinsing in acetone for 10 minutes. Thus obtained nickel electrode film was examined with a microscope and no delamination of the film was observed.

### Example 2

A conductive ink (conductive ink B) was obtained as in the case of Example 1 except that an aminosilane coupling agent KBE-903 (manufactured by Shin-Etsu Chemical Co., Ltd.) was used instead of titanium lactate. And a nickel electrode film was obtained with a spin coater. As for the nickel electrode film, the resistivity was measured and the adhesion was examined as in the case of Example 1. The resistivity was 4. 5 × 10⁻³ Ω·cm. The adhesion was evaluated to be class 0, which means that excellent adhesion was obtained. Furthermore, the nickel electrode film was subjected to ultrasonic rinsing in water for 10 minutes, followed by ultrasonic rinsing in acetone for 10 minutes. As a result, no delamination of the nickel electrode film was observed. After that, a fine nickel electrode film was formed on a glass substrate by the coating method with a dispenser as in the case of Example 1. Measurement with a microscope showed that the nickel electrode had a width of about 40 µm. The obtained nickel electrode film was subjected to ultrasonic rinsing in water for 10 minutes, followed by ultrasonic rinsing in acetone for 10 minutes. Thus obtained nickel electrode film was examined with a microscope and no delamination of the film was observed.

### Example 3

A fine nickel electrode film was formed on a glass substrate with an ITO film (0.2 µm thick ITO film, manufactured by MITSUI MINING & SMELTING CO., LTD) by the coating method with a dispenser by conducting processes as in the case of Example 1 except that a substrate on which the nickel electrode film was formed was changed to the glass substrate with the ITO film. Measurement with a microscope showed that the nickel electrode had a width of about 40 µm. The obtained nickel electrode film was subjected to ultrasonic rinsing in water for 10 minutes, followed by ultrasonic rinsing in acetone for 10 minutes. Thus obtained nickel electrode film was examined with a microscope and no delamination of the film was observed.

### Example 4

A fine nickel electrode film was formed on a copper-clad laminate (manufactured by MITSUI MINING & SMELTING CO., LTD., with 35 µm thick copper foils) by the coating method with a dispenser by conducting processes as in the case of Example 1 except that a substrate on which the nickel electrode film was formed was changed to the copper-clad laminate. Measurement with a microscope showed that the nickel electrode had a width of about 40 µm. The obtained nickel electrode film was subjected to ultrasonic rinsing in water for 10 minutes, followed by ultrasonic rinsing in acetone for 10 minutes. Thus obtained nickel electrode film was examined with a microscope and no delamination of the film was observed.

Hereinafter, evaluation on a circuit formed by using an ink jet printer after adjusting the viscosity of a conductive ink in Examples 5 to 7 will be described.

### Example 5

### (Preparation of Metal Powder of Minute Particles)

In this Example, an inorganic oxide coated minute nickel powder was used as the metal powder of minute particles. Hereinafter, preparation of the inorganic oxide coated particulate nickel powder will be explained. 10 L of pure water was added to a 20-L-volume container. And 4000 g of a nickel powder (NN-100 manufactured by MITSUI MINING & SMELTING CO., LTD., an average diameter of primary particles: 100 nm) was slowly added to the container with stirring at 200 rpm, and the stirring was kept for 20 minutes. Then 200 g of 20 wt% colloidal silica (SNOWTEX 0 manufactured by Nissan Chemical Industries, Ltd., an average diameter of primary particles: 20 nm) was added to this mixture, and further stirred for 20 minutes to obtain a dispersion fluid.

Then in order to obtain the state that the colloidal silica was mixed uniformly with the nickel powder in the dispersion fluid, mixing treatments were conducted continuously by using T. K. FILMICS (manufactured by Tokushu Kika Kogyo), which is a high-speed emulsifying disperser, to obtain a slurry having the state that the colloidal silica was mixed uniformly with the nickel. Subsequently, this slurry was subjected to a drying treatment with a vacuum dryer for 24 hours under the conditions, a vacuum degree of 50 Torr or less, and the temperature in the dryer of 120t to obtain a dry powder in which the silica is coated to the surface of particles of the nickel powder. After that, this dry powder was crushed with a Henschel mixer (manufactured by MITSUI MINING COMPANY, LIMITED), and then classified with a 20 µm sieve to remove coarse particles. Then in order to improve adhesion of the silica which was on the surface of powdery nickel particles passed through the 20 µm sieve to the surface of the nickel particles, additional heat treatment was conducted with a vacuum dryer for 24 hours under the conditions, vacuum degree of 10 Torr or less, and the temperature in the dryer of 150°C to obtain a silica-coated nickel powder (hereafter referred to as "nickel powder"). The nickel powder was a powder in which the silica was coated to the surface of nickel fine particles.

### (Dispersing Agent)

380 g of diethanolamine (manufactured by Wako Pure Chemical Industries, Ltd.), 45.6 g of 44% solution of ammonium polyacrylate (manufactured by Wako Pure Chemical Industries, Ltd.), and 13.4 g of 15% solution of tetramethyl ammonium (manufactured by Wako Pure Chemical Industries, Ltd.) was added to a 1-L-volume beaker, and stirred with a magnetic stirrer to prepare a dispersing agent.

### (Preparation of aqueous Nickel Slurry)

0.7 L of pure water as a solvent was added to a 1-L-volume container. And 300 g of the nickel powder was slowly added to the container with stirring at 200 rpm, and further 40.3 g of the dispersing agent was added thereto. Then the stirring was kept for 20 minutes to obtain a slurry.

After that, the slurry was subjected to dispersing treatments continuously by using T.K. FILMICS (manufactured by Tokushu Kika Kogyo), which is a high-speed emulsifying disperser, and then 0. 96 L of pure water was added thereto to obtain a slurry with a nickel content of 15 wt%.

Next, 1 µm or larger particles contained in the slurry were removed by filtering the slurry with a cartridge type filter (MCP-JX-E10S manufactured by Advantec Toyo Kaisha, Ltd., an average pore size: 1 µm or less) . Furthermore, in order to remove 0.8 µm or larger particles, the slurry was filtered with Mixed Cellulose Ester Membrane Filter A065A293C (manufactured by Advantec Toyo Kaisha, Ltd., an average pore size: 0.65 µm) to obtain a filtrate (hereafter referred to as "aqueous nickel slurry")

### (Preparation of Conductive Ink)

As for the aqueous nickel slurry, 188.9 g of 2-n-butoxyethanol (a surface tension of 28.2 mN/m, manufactured by KANTO CHEMICAL CO., INC.) as a surface tension adjustor was added to the filtrate and stirred at 200 rpm for 30 minutes. Furthermore, 65.8 g of titanium lactate (TC-315 manufactured by Matsumoto Pure Chemical Industries, Ltd.) was added thereto as an adhesion improver, and stirred at 200 rpm for 30 minutes to obtain a conductive ink (hereafter referred to as "conductive ink A"). The surface tension of the conductive ink A of Example 5 was 32.5 mN/m as a result of measurement with a dynamic contact angle meter (DCA-100W manufactured by A&D Company, Ltd.). The viscosity of the conductive ink A of Example 5 at 25°C was 10.8 cP as a result of measurement with an oscillation viscometer (VM-100A manufactured by CBC Materials Co., LTD.).

### (Evaluation of Printability)

The conductive ink A of Example 5 was used to form a wiring pattern (100 µm line and space, and 2 cm long) on an alkalifree glass substrate OA-10 (manufactured by Nippon Electric Glass Co., Ltd.) with a commercially available ink jet printer (PM-G700 manufactured by SEIKO EPSON CORPORATION). The conductive ink A of Example 5 was printed without clogging the ink jet nozzle. Furthermore, continuous printing of 50 times and more was performed. After the continuous printing of 50 times, printing patterns for checking clogging of the nozzle was conducted, and no clogging of the nozzle was observed. And investigation on the obtained wiring pattern with an optical microscope showed no breakage or scattering of the ink in the wiring pattern, which means that an excellent wiring pattern was obtained.

### (Evaluation of Conductivity)

Next, a 3 cm square solid film was formed on a 4 cm square glass substrate with the ink jet printer, and the substrate was subjected to a heat treatment in a hydrogen-nitrogen mixed atmosphere containing hydrogen of 2 volume percent, at 300t for 2 hours to obtain an electrode film. A resistivity of the electrode film was measured with a 4-pin probe Resistivity Meter Loresta-GP (manufactured by Mitsubishi Chemical Corporation). The resistivity was 1.8 × 10⁻³ Ω·cm.

### (Evaluation of Adhesion)

After that, adhesion of the electrode film prepared above to the glass substrate was evaluated by the crosscut method according to JIS K 5600 paragraph 5-6. As a result, the adhesion was evaluated to be class 0, which means that excellent adhesion was obtained. Furthermore, the electrode film was subjected to ultrasonic rinsing in water for 10 minutes, followed by ultrasonic rinsing in acetone for 10 minutes. As a result, no delamination of the electrode film was observed. Evaluation results etc. mentioned above are shown in Table 1 along with other Examples and Comparative Example.

### Example 6

In this Example, a conductive ink (hereafter referred to as conductive ink B") was obtained as in the case of Example 5 except that 89.5 g of 1-butanol (a surface tension of 24.9mN/m, manufactured by KANTO CHEMICAL CO., INC.) was added as a surface tension adjustor instead of 2-n-butoxyethanol. The conductive ink B had a surface tension of 41.8 mN/m and a viscosity of 10.5 cP at 25°C.

Hereinafter, a wiring pattern was formed as in the case of Example 5, and the conductive ink B was printed without clogging the ink jet nozzle. Furthermore, continuous printing of 50 times and more was performed.

In addition, investigation on the obtained wiring pattern with an optical microscope showed no breakage or scattering of the ink in the wiring pattern, which means that an excellent wiring pattern was obtained. Furthermore, an electrode film was formed as in the case of Example 1, and the resistivity of the film was measured to be 2.3×10⁻² Ω·cm. The adhesion of the electrode film was evaluated as in the case of Example 5 to be class 0, which means that excellent adhesion was obtained. Furthermore, the electrode film was subjected to ultrasonic rinsing in water for 10 minutes, followed by ultrasonic rinsing in acetone for 10 minutes. As a result, no delamination of the electrode film was observed. Evaluation results etc. mentioned above are shown in Table 1 along with other Examples and Comparative Example.

### Example 7

In this Example, an inorganic oxide coatedminute silver powder was used as the metal powder of minute particles. Hereinafter, preparation of the inorganic oxide coated minute silver powder will be explained. 10 L of pure water was added to a 20-L-volume container. And 4000 g of a minute silver powder (manufactured by MITSUI MINING & SMELTING CO., LTD., an average diameter of primary particles: 0.3 µm) was slowly added to the container with stirring at 200 rpm, and the stirring was kept for 20 minutes. Then 200 g of 20 wt% colloidal silica (SNOWTEX 0 manufactured by Nissan Chemical Industries, Ltd., an average diameter of primary particles: 20 nm) was added to this mixture, and further stirred for 20 minutes to obtain a dispersion fluid.

Then in order to obtain the state that the colloidal silica was mixed uniformly with the particulate silver powder in the dispersion fluid, mixing treatments were conducted continuously by using T. K. FILMICS, which is a high-speed emulsifying disperser, to obtain a slurry having the state that the colloidal silica was mixed uniformly with the particulate silver powder. Subsequently, this slurry was subjected to a drying treatment with a vacuum dryer for 24 hours under the conditions that the temperature in the dryer was 50°C and a vacuum degree of 50 Torr or less to obtain a dry powder in which the silica was coated to the surface of particles of the particulate silver powder. After that, this dry powder was crushed with a Henschel mixer (manufactured by MITSUI MINING COMPANY, LIMITED), and then classified with a 20 µm sieve to remove coarse particles. Then in order to improve adhesion of the silica which was on the surface of powdery silver particles passed through the 20 µm sieve to the surface of the silver particles, additional heat treatment was conducted with a vacuum dryer for 24 hours under the conditions, vacuum degree of 10 Torr or less, and the temperature in the dryer was 70°C to obtain a silica-coated minute silver powder (hereafter referred to as "silver powder"). The silver powder was a powder in which the silica was coated to the surface of silver fine particles.

Then 0.7 L of pure water as a solvent was added to a 1-L-volume container. And 300 g of the silver powder was slowly added to the container with stirring at 200 rpm, and further 40.3 g of a dispersing agent was added thereto. Then the stirring was kept for 20 minutes to obtain a slurry.

After that, the slurry was subjected to dispersing treatments continuously by using T.K. FILMICS (manufactured by Tokushu Kika Kogyo), which is a high-speed emulsifying disperser, and then 0. 96 L of pure water was added to obtain a slurry with a silver content of 15 wt%.

Next, 1 µm or larger particles contained in the slurry were removed by filtering the slurry with the cartridge type filter and the Mixed Cellulose Ester Membrane Filter as in the case of Example 5 to obtain a filtrate (hereafter referred to as "aqueous silver slurry").

Furthermore, to the aqueous silver slurry, 188.9 g of 2-n-butoxyethanol as a surface tension adjustor was added and stirred at 200 rpm for 30 minutes. Furthermore, 65.8 g of titanium lactate was added thereto as an adhesion improver, and stirred at 200 rpm for 30 minutes to obtain a conductive ink (hereafter referred to as "conductive ink C"). Measurements showed that the surface tension of the conductive ink C was 34.8 mN/m, and the viscosity of the conductive ink C at 25°C was 10.8 cP.

Hereinafter, a wiring pattern was formed as in the case of Example 5, and the conductive ink C was printed without clogging the ink jet nozzle. Furthermore, continuous printing of 50 times and more was performed.

In addition, investigation on the obtained wiring pattern with an optical microscope showed no breakage or scattering of the ink in the wiring pattern, which means that an excellent wiring pattern was obtained. Furthermore, an electrode film was formed as in the case of Example 5, and the resistivity of the film was measured to be 3.5×10⁻⁴Ω·cm. The adhesion of the electrode film was evaluated as in the case of Example 1 to be class 0, which meant that excellent adhesion was obtained. Furthermore, the electrode film was subjected to ultrasonic rinsing in water for 10 minutes, followed by ultrasonic rinsing in acetone for 10 minutes. As a result, no delamination of the electrode film was observed. Evaluation results etc. mentioned above are shown in Table 1 along with other Examples and Comparative Example.

### Comparative Example 1

A conductive ink D (hereafter referred to as "conductive ink D") was obtained as in the case of Example 5 except that addition of 2-n-butoxyethanol was omitted. The conductive ink D had a surface tension of 53.1 mN/m, and a viscosity of 10.4 cP at 25°C. A wiring pattern was formed as in the case of Example 5, but the conductive ink D clogged the ink jet nozzle after 5 times of printing, and thus continuous printing was not able to conduct any more. And investigation on the wiring pattern with an optical microscope showed breakage in the wiring pattern, and it was impossible to obtain an excellent wiring pattern.

In addition, it was tried to form an electrode film as in the case of Example 5, but it was impossible to form the electrode film because the conductive ink D lacks wettability to the glass substrate. Evaluation results etc. mentioned above are shown in Table 1 along with other Examples.

**[Table 1]**

| | | Example 5 | Example 6 | Example 7 | Comparative Example 1 |
|---|---|---|---|---|---|
| Metal powder | | Nickel | Nickel | Silver | Nickel |
| Adhesion improver | | Titanium lactate | Titanium lactate | Titanium lactate | Titanium lactate |
| Surface tension adjustor | | 2-n-butoxy ethanol | 1-butanol | 2-n-butoxy ethanol | None |
| Surface tension | mN/m | 32.5 | 41.8 | 34.8 | 53.1 |
| viscosity | cP | 10.8 | 10.5 | 10.8 | 10.4 |
| Ink jet printing test | Clogging of ink jet nozzle | None | None | None | Present |
| | Breakage of wiring | None | None | None | Present |
| characteristics of the Electrode | Resistivity of electrode film | 1.8×10⁻³ | 2. 3×10⁻² | 3.5×10⁻⁴ | impossible to form Electrode film |
| Film | Adhesion (JIS K 5600) | Class 0 | Class 0 | Class 0 | Impossible to form Electrode film |

### Industrial Applicability

The conductive ink according to the present invention has an excellent adhesion to various kinds of substrates and makes it possible to form fine wiring or electrodes. Furthermore, the conductive ink according to the present invention is suitable for forming fine wiring, electrodes, etc. by employing the ink jet printing system or the dispenser system. When the ink jet printing system etc. is used, use of additives such as an adhesion improver provides a conductive metal ink having excellent adhesion to various kinds of substrates and making it possible to form fine wiring or electrodes. Therefore, the conductive ink makes it possible to form circuits on glass substrates, circuits made from a silver paste or a copper paste, or wiring, electrodes protective circuits, or protective films on transparent electrodes using ITO etc. Accordingly, the conductive ink is useful for manufacturing processes for liquid crystal displays etc. Such a conductive ink that makes it possible to print fine wiring or electrodes by dispenser devices or ink jet devices and ensures excellent adhesion to various kinds of substrates is not introduced on the market. Therefore, use of the conductive ink according to the present invention will be spread dramatically.

## Claims

1. A conductive ink comprising a solvent, a metal powder, and an adhesion improver, which is **characterized in that** the adhesion improver is one or mixture selected from the group consisting of a silane coupling agent, a titanium coupling agent, a zirconium coupling agent, and an aluminum coupling agent, whereby the conductive ink has a viscosity of 60 cP or less at 25°C.

2. The conductive ink according to claim 1, which is **characterized in that** a surface tension of the solvent is adjusted to be in the range of 15 mN/m to 50 mN/m with a surface tension adjustor.

3. The conductive ink according to claim 2, wherein the surface tension adjustor is one or mixture selected from the group consisting of alcohols and glycols which have a boiling point of from 100 to 300°C at ambient pressure.

4. The conductive ink according to any one of claims 1 to 3, which is **characterized in that** the solvent is one or mixture selected from the group consisting of water, alcohols and saturated hydrocarbons which have a boiling point of 300°C or less at ambient pressure.

5. The conductive ink according to any one of claims 1 to 4, wherein the metal powder is selected from the group consisting of a nickel powder, a silver powder, a gold powder, a platinum powder, a copper powder, and a palladium powder; and the metal powder has a primary particle size of 500 nm or less.

6. The conductive ink according to claim 5, wherein the agglomerate particles contained in the metal powder have the maximum particle size of 0.8 µm or less.

7. The conductive ink according to any one of claims 1 to 6, wherein the metal powder is an inorganic oxide coated nickel powder in which an insoluble inorganic oxide is coated to the surface of particles of the powder.

8. The conductive ink according to claim 7, which is **characterized in that** the insoluble inorganic oxide is an oxide containing at least one element selected from the group consisting of silicon dioxide, aluminum oxide, zirconium oxide, and titanium oxide.

9. The conductive ink according to any one of claims 1 to 8, wherein one or mixture selected from the groups of (a) polyacrylic acids, esters or salts thereof; (b) organic functional group substituted ammonium hydroxides; and (c) hydroxyl functional group containing amine compounds, are added as a dispersing agent.

## Patentansprüche

1. Leitfähige Tinte umfassend ein Lösungsmittel, ein Metallpulver und ein Adhäsionsverbesserungsmittel, **dadurch gekennzeichnet, dass** das Adhäsionsverbesserungsmittel ein solches ist, das ausgewählt ist aus der Gruppe bestehend aus einem Silanhaftmittel, einem Titanhaftmittel, einem Zirkoniumhaftmittel und einem Aluminiumhaftmittel, oder eine Mischung davon, wobei die leitfähige Tinte eine Viskosität von 60 cP oder weniger bei 25°C aufweist.

2. Leitfähige Tinte nach Anspruch 1, **dadurch gekennzeichnet, dass** eine Oberflächenspannung des Lösungsmittels mit einem Oberflächenspannungseinstellmittel so eingestellt wird, dass sie im Bereich von 15 mN/m bis 50 mN/m liegt.

3. Leitfähige Tinte nach Anspruch 2, wobei das Oberflächenspannungseinstellmittel ein solches ist, das ausgewählt ist aus der Gruppe bestehend aus Alkoholen und Glykolen, die bei Umgebungsdruck einen Siedepunkt von 100 bis 300°C aufweisen, oder eine Mischung davon.

4. Leitfähige Tinte nach einem der Ansprüche 1 bis 3, **dadurch gekennzeichnet, dass** das Lösungsmittel ein solches ist, das ausgewählt ist aus der Gruppe bestehend aus Wasser, Alkoholen und gesättigten Kohlenwasserstoffen, die bei Umgebungsdruck einen Siedepunkt von 300°C oder weniger aufweisen, oder eine Mischung davon.

5. Leitfähige Tinte nach einem der Ansprüche 1 bis 4, wobei das Metallpulver ausgewählt ist aus der Gruppe bestehend aus einem Nickelpulver, einem Silberpulver, einem Goldpulver, einem Platinpulver, einem Kupferpulver und einem Palladiumpulver, und wobei das Metallpulver eine Primärpartikelgröße von 500 nm oder weniger aufweist.

6. Leitfähige Tinte nach Anspruch 5, wobei die Agglomeratpartikel, die in dem Metallpulver enthalten sind, die maximale Partikelgröße von 0,8 µm oder weniger aufweisen.

7. Leitfähige Tinte nach einem der Ansprüche 1 bis 6, wobei das Metallpulver ein mit einem anorganischen Oxid beschichtetes Nickelpulver ist, bei dem die Partikeloberfläche des Pulvers mit einem unlöslichen anorganischen Oxid beschichtet ist.

8. Leitfähige Tinte nach Anspruch 7, **dadurch gekennzeichnet, dass** das unlösliche anorganische Oxid ein Oxid ist, das wenigstens ein Element enthält, das ausgewählt ist aus der Gruppe bestehend aus Siliziumdioxid, Aluminiumoxid, Zirkoniumoxid und Titanoxid.

9. Leitfähige Tinte nach einem der Ansprüche 1 bis 8, wobei als ein Dispersionsmittel ein solches hinzugegeben ist, das ausgewählt ist aus den Gruppen (a) Polyacrylsäuren, -Ester oder Salze davon; (b) Ammoniumhydroxide, die mit einer organischen funktionalen Gruppe substituiert sind; und (c) Aminverbindungen, die eine funktionale Hydroxylgruppe enthalten, oder eine Mischung davon.

## Revendications

1. Encre conductrice comprenant un solvant, une poudre métallique et un renforçateur d'adhérence, qui est **caractérisée en ce que** le renforçateur d'adhérence est un agent ou un mélange d'agents choisis dans le groupe constitué d'un agent de couplage au silane, d'un agent de couplage au titane, d'un agent de couplage au zirconium et d'un agent de couplage à l'aluminium, l'encre conductrice possédant une viscosité de 60 cP ou moins à 25 °C.

2. Encre conductrice selon la revendication 1, laquelle est **caractérisée en ce que** la tension superficielle du solvant est réglée pour se situer dans la plage de 15 mN/m à 50 mN/m avec un régulateur de tension superficielle.

3. Encre conductrice selon la revendication 2, dans laquelle le régulateur de tension superficielle est un élément ou un mélange d'éléments choisis dans le groupe constitué d'alcools et de glycols dont le point d'ébullition varie de 100 à 300 °C à la pression ambiante.

4. Encre conductrice selon l'une quelconque des revendications 1 à 3, laquelle est **caractérisée en ce que** le solvant est un solvant ou un mélange de solvants choisis dans le groupe constitué de l'eau, d'alcools et d'hydrocarbures saturés dont le point d'ébullition est de 300 °C ou moins à la pression ambiante.

5. Encre conductrice selon l'une quelconque des revendications 1 à 4, dans laquelle la poudre métallique est choisie dans le groupe constitué d'une poudre de nickel, d'une poudre d'argent, d'une poudre d'or, d'une poudre de platine, d'une poudre de cuivre et d'une poudre de palladium ; et la poudre métallique possède une dimension principale de particules de 500 nm ou moins.

6. Encre conductrice selon la revendication 5, dans laquelle la taille de particules maximale des particules d'agglomérat contenues dans la poudre métallique est de 0,8 µm ou moins.

7. Encre conductrice selon l'une quelconque des revendications 1 à 6, dans laquelle la poudre métallique est une poudre de nickel enduite d'oxyde inorganique dans laquelle un oxyde inorganique insoluble est enduit sur la surface des particules de la poudre.

8. Encre conductrice selon la revendication 7, laquelle est **caractérisée en ce que** l'oxyde inorganique insoluble est un oxyde contenant au moins un élément choisi dans le groupe constitué du dioxyde de silicium, de l'oxyde d'aluminium, de l'oxyde de zirconium et de l'oxyde de titane.

9. Encre conductrice selon l'une quelconque des revendications 1 à 8, dans laquelle un élément ou un mélange d'éléments sélectionnés dans le groupe (a) d'acides polyacryliques, d'esters ou de sels de ceuxci ; (b) d'hydroxydes d'ammonium à substitution par un groupe fonctionnel organique ; et (c) de composés aminés contenant un groupe fonctionnel hydroxyle, sont ajoutés en tant qu'agent de dispersion.
